# FASCICULE DE BREVET EUROPEEN

(11) **EP 2 355 156 B1**
(45) Date de publication et mention de la délivrance du brevet: **25.12.2013**
(21) Numéro de dépôt: 10197102.6
(22) Date de dépôt: 28.12.2010
(51) Int. Cl.: H01L 27/146

(54) **Photodiode de capteur d'image**
Fotodiode für Bildsensor
Photodiode for image sensor

(30) Priorité: 28.01.2010 FR 1050565
(43) Date de publication de la demande: 10.08.2011
(73) Titulaire: STMicroelectronics (Crolles 2) SAS, 38920 Crolles (FR)
(72) Inventeur: Roy, François, 38180, SEYSSINS (FR)
(74) Mandataire: Thibon, Laurent

(56) Documents cités:
- EP-A2- 1 562 233
- FR-A1- 2 910 713
- US-A1- 2005 179 053
- US-A1- 2005 230 720
- US-A1- 2007 194 356
- US-A1- 2009 200 588
- J. PRIMA, F. ROY, H. LEININGER, CH. COWACHE, J. VAILLANT, L. PINZELLI, D. BENOIT, N. MOUSSY, B. GIFFARD: "Improved color separation for a backside illuminated image sensor with 1.4 um pixel pitch", 2009 INTERNATIONAL IMAGE SENSOR WORKSHOP (IISW), 25 juin 2009 (2009-06-25), - 28 juin 2009 (2009-06-28), XP002592900, Bergen, Norway
- F. HIRIGOYEN, J. VAILLANT, E. HUSS, F. BARBIER, J. PRIMA, F. ROY, D. HÉRAULT: "1,1um Backside Imager vs. Frontside Imager: an optics-dedicated FDTD approach", 2009 INTERNATIONAL IMAGE SENSOR WORKSHOP (IISW), 25 juin 2009 (2009-06-25), - 28 juin 2009 (2009-06-28), XP002592896, Bergen, Norway

## Description

### Domaine de l'invention

La présente invention concerne un capteur d'image et un procédé de formation d'un capteur d'image, et en particulier un capteur d'image comprenant un réseau de pixels.

### Arrière-plan de l'invention

Des capteurs d'image monolithiques comprennent des photodiodes et des transistors formés dans un substrat de silicium. Plus particulièrement, de tels capteurs d'image comprennent un réseau de pixels dont chacun comprend une photodiode pincée couplée à un noeud de lecture par un transistor de transfert. La charge accumulée par la photodiode pendant une durée d'intégration peut être transférée au noeud de lecture par le transistor de transfert.

La lecture de la tension stockée sur le noeud de lecture est réalisée en utilisant un circuit de lecture, comprenant généralement un transistor à source suiveuse dont la grille est couplée au noeud de lecture. En outre, un transistor de remise à zéro est également couplé à la source, permettant à la tension sur la source d'être remise à zéro après chaque lecture. Pour réduire le nombre de composants, le circuit de lecture est souvent partagé par une ou plusieurs photodiodes.

La sensibilité et donc la qualité du capteur d'image sont dans une certaine mesure déterminées par la capacité de stockage de charge de chaque photodiode du capteur d'image. En particulier, si la photodiode se sature pendant une durée d'intégration et ne peut plus stocker davantage de charge, il en résulte une réduction de la qualité d'image.

La demande de brevet européenne EP1562233 concerne un dispositif de détection d'image comprenant un substrat sur lequel sont formés une photodiode et un transistor d'un pixel.

La demande de brevet US2005/0230720 concerne un capteur d'image comprenant un substrat semiconducteur ayant une pluralité de pixels, chacun comprenant une couche d'impuretés, une couche photoélectrique de conversion, une région de lecture et une électrode de grille.

La demande de brevet US2009/0200588 concerne un capteur d'image éclairé par la face arrière comprenant un pixel comportant une photodiode, une couche d'isolation et une couche réfléchissante.

La demande de brevet US2005/0179053 concerne un capteur d'image capable de réduire les courants d'obscurité et des défauts de pixel.

La demande de brevet US2007/0194356 concerne un capteur d'image comprenant un substrat, une première région d'isolation, une deuxième région d'isolation, une pluralité de dispositifs photoélectriques, un élément de lecture et une région de diffusion flottante.

La publication ayant pour titre "Improved color separation for a backside illuminated image sensor with 1.4 µm pixel pitch", Jens Prima et al., 2009 International Image Sensor Workshop, 25 juin 2009 - 28 juin 2009, concerne un capteur d'image éclairé par la face arrière ayant une dimension caractéristique de 1.4 µm.

La publication ayant pour titre "1.1 µm Backside Imager vs. Frontside Imager: an optics-dedicated FDTD approach", Flavien Hirigoyen et al., 2009 International Image Sensor Workshop, 25 juin 2009 - 28 juin 2009, concerne un capteur d'image CMOS comprenant un pixel de 1.4 µm.

### Résumé de l'invention

Des modes de réalisation de la présente invention visent à traiter au moins partiellement un ou plusieurs des problèmes de l'art antérieur.

Selon un aspect de la présente invention, il est prévu un capteur d'image selon la revendication 1.

Selon un mode de réalisation, d'au moins un côté, une des régions de type P entre la région de recueil de charge et une tranchée d'isolement est plus fortement dopée.

Selon un mode de réalisation, la région de recueil de charge est délimitée sur au moins un côté par une région de substrat de type P, et dans lequel la couche de type P a une concentration de dopage plus faible que le substrat de type P.

Selon un mode de réalisation, une région de lecture est disposée à côté de l'électrode de grille isolée, et l'électrode de grille isolée est agencée pour que ladite tension de grille transporte des charges à travers la couche de type P vers la région de lecture.

Selon un mode de réalisation, le noeud de lecture recouvre partiellement la région de recueil de charge.

Selon un mode de réalisation, la région de recueil de charge a une profondeur comprise entre 0,5 et 2 µm.

Selon un mode de réalisation, la région de recueil de charge a une largeur comprise entre 0,05 et 0,4 µm.

Selon un mode de réalisation, la région de type N de la région de recueil de charge a une concentration de dopage dans la plage de 10¹⁵ à 5x10¹⁷ at./cm³.

Selon un mode de réalisation, la couche de type P a une concentration de dopage comprise entre 10¹⁶ et 10¹⁸ at./cm³.

Selon un mode de réalisation, la couche de type P a une épaisseur comprise entre 20 et 150 nm.

Selon un mode de réalisation, chaque pixel comprend en outre un transistor à source suiveuse formé dans une région de pixel délimitée par des tranchées d'isolement, le transistor à source suiveuse étant isolé d'au moins un côté par isolement à tranchée peu profonde.

Selon un aspect de la présente invention, il est prévu un dispositif électronique comprenant le capteur d'image ci-dessus.

Selon un aspect de la présente invention, il est prévu un téléphone mobile comprenant le capteur d'image ci-dessus.

Selon un aspect de la présente invention, il est prévu un procédé de fabrication d'un capteur d'image selon la revendication 12.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe représentant un exemple d'un pixel d'un capteur d'image ;
la figure 2 est une vue en coupe représentant un pixel d'un capteur d'image selon un mode de réalisation de la présente invention ;
la figure 3 est un graphique illustrant des concentrations de dopants pour former une photodiode du pixel de la figure 2 selon un mode de réalisation de la présente invention ;
la figure 4 représente schématiquement un exemple de circuit de pixel ; et
la figure 5 représente un dispositif de capture d'image électronique selon des modes de réalisation de la présente invention.

Dans les figures, de mêmes éléments sont désignés par de mêmes références. En outre, des références directionnelles dans la présente description telles que en surplomb, recouvrant, latérales, au-dessus, en dessous, etc. s'appliquent à des circuits orientés de la façon illustrée dans les vues en coupe correspondantes.

### Description détaillée

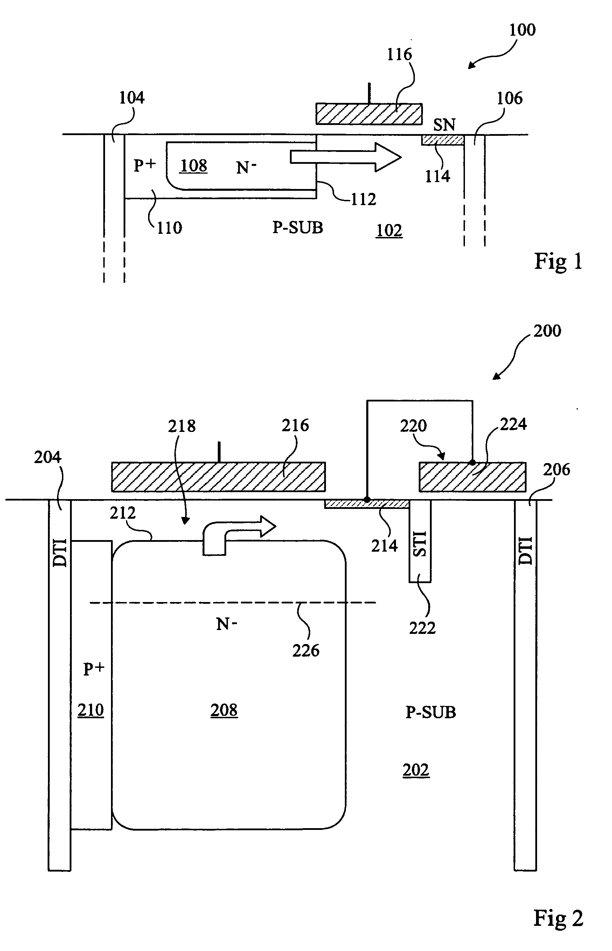

La figure 1 est une vue en coupe illustrant un pixel 100 d'un capteur d'image. Comme cela est représenté, dans un substrat de silicium de type P 102, une région de pixel est délimitée des deux côtés par des tranchées d'isolement 104, 106. Une photodiode est formée près de la surface du substrat de type P 102 et comprend une région de type N légèrement dopée 108 entourée d'une région de type P fortement dopée 110, de tous côtés sauf d'un côté latéral 112. Des charges résultant de la lumière frappant la région de pixel du pixel 100 sont accumulées dans la région 108 pendant une phase d'intégration du capteur d'image. Ces charges sont ensuite transférées pendant une phase de transfert de la région 108 vers un noeud de lecture 114 par un transistor de transfert comprenant un empilement de grille formé à la surface du substrat de type P 102 entre la région de type P fortement dopée 110 et le noeud de lecture 114. Lors d'un transfert, des charges quittent la région 108 par le côté 112 vers le noeud de lecture 114 en passant par un canal produit en appliquant une tension de transfert à l'électrode de grille 116 du transistor de transfert.

Comme cela a été expliqué ci-dessus, il serait souhaitable d'augmenter le volume de la région de type N 108 pour que plus de charges puissent être stockées. Toutefois, la largeur de la région de type N 108 est limitée par la largeur du pixel et ne peut donc être augmentée sans augmenter la largeur du pixel, d'où il résulterait une augmentation de la dimension totale du capteur d'image. D'autre part, il est difficile d'augmenter l'épaisseur de la région de type N 108 dans l'agencement de la figure 1 car ceci conduirait à une plus grande distance entre des parties de la région de type N 108 et l'électrode de grille 116 du transistor de transfert, ce qui conduirait à un transfert de charge inadéquat pendant la phase de transfert.

La figure 2 est une vue en coupe illustrant un pixel 200 formé dans un substrat de type P 202 et délimité des deux côtés par des isolements à tranchées profondes (DTI) 204, 206. La photodiode du pixel 200 est constituée d'une région de type N faiblement dopée (N⁻) 208 dans le substrat de type P 202. Dans ce mode de réalisation, la région 208 a une largeur légèrement inférieure à la largeur de la région de type N 108 de la figure 1 mais une beaucoup plus grande épaisseur. En particulier, alors que l'épaisseur de la région de type N 108 est par exemple voisine de 0,2 µm et sa largeur voisine de 0,4 µm, l'épaisseur de la région 208 est par exemple d'environ 1,2 µm et sa largeur d'environ 0,2 µm, et ceci implique donc une augmentation d'ensemble du volume de 50 pourcent.

Dans des variantes de réalisation, la région 208 peut avoir une largeur dans la plage de 0,05 à 0,4 µm et une profondeur dans la plage de 0,5 à 2 µm.

Une région de type P fortement dopée (P⁺) 210 forme une barrière disposée entre la région de type N 208 et la tranchée profonde 204.

Dans cet exemple, le noeud de lecture 214, constitué par exemple d'une région de type N fortement dopée, est disposé d'un côté en projection de la région de type N 208 et déborde partiellement au-dessus de cette région 208.

Le transfert de charge de la région de type N 208 au noeud de lecture 214 est possible en raison d'une structure différente du transistor de transfert dans le pixel 200 par rapport au cas du pixel 100. En particulier, l'empilement de grille du transistor de transfert est formé directement au-dessus de la région de type N 208. En figure 2, par souci de clarté, seule l'électrode isolée de grille 216 de l'empilement de grille du transistor de transfert est représentée et non pas l'isolant de grille, les espaceurs, etc.. La région de type N 208 est par exemple espacée de la surface du substrat de type P d'une distance d'environ 100 nm, ce qui laisse une couche 218 de silicium de type P ayant la même concentration de dopage que le substrat de type P 202 ou une concentration légèrement inférieure, par exemple entre 10¹⁶ et 10¹⁸ at./cm³, à travers laquelle des charges sont transférées vers le noeud de lecture 214 pendant la phase de transfert. Ainsi, pendant le transfert de la région de type N 208 au noeud de lecture 214, des charges sont attirées dans la région de canal 218 par une tension positive appliquée à l'électrode de grille 216, comprise par exemple entre 1 et 3 V, et, une fois dans la couche de type P 218, les charges sont attirées vers la région de source formée par le noeud de lecture 214.

De plus, la région de type P 210 aide à empêcher la génération du courant d'obscurité et à assurer le vidage des charges en les repoussant quand une tension de transfert est appliquée à l'électrode de grille 216. Dans des variantes de réalisation, une telle barrière n'est pas utilisée, par exemple s'il y a un plus grand écart entre la région de type N 208 et le bord du pixel 100 ou si la tranchée 204 est active, ce qui signifie qu'elle contient un corps conducteur auquel peut être appliqué une tension qui aide à la fois à empêcher la génération du courant d'obscurité à l'interface oxyde/silicium de la tranchée DTI 204, et à assurer le vidage des charges quand la tension de transfert est appliquée.

Dans des variantes de réalisation, l'épaisseur de la couche de type P 218 séparant la région de type N 208 de la couche d'isolement du transistor de transfert pourrait être comprise entre 20 et 150 nm.

Dans ce mode de réalisation, un transistor 220 formant un transistor à source suiveuse pour lire la tension sur le noeud de lecture 214 est également disposé dans la région de pixel du pixel 200. Ce transistor 220 est isolé du reste du pixel par un isolement à tranchée peu profonde (STI) 222 et est disposé entre l'isolement à tranchée peu profonde 222 et l'isolement à tranchée profonde 206. L'électrode de grille 224 du transistor 220 est couplée au noeud de lecture 214. La source et le drain du transistor 220 (non représentés en figure 2) sont par exemple formés de part et d'autre de l'empilement de grille entre l'isolement à tranchée peu profonde 222 et l'isolement à tranchée profonde 206.

Pendant la phase d'intégration, la lumière tombant sur la région de pixel délimitée par les isolements à tranchée profonde 204, 206 fournit une accumulation de charges dans la région 208. Le capteur d'image est par exemple éclairé par la face arrière. En d'autres termes, il est disposé de sorte que la lumière tombe sur la face du dispositif opposée à celle sur laquelle le transistor de transfert est formé. Ainsi, la profondeur supplémentaire de la région de type N 208 facilite l'accumulation des charges résultant de la lumière arrivant de la face arrière.

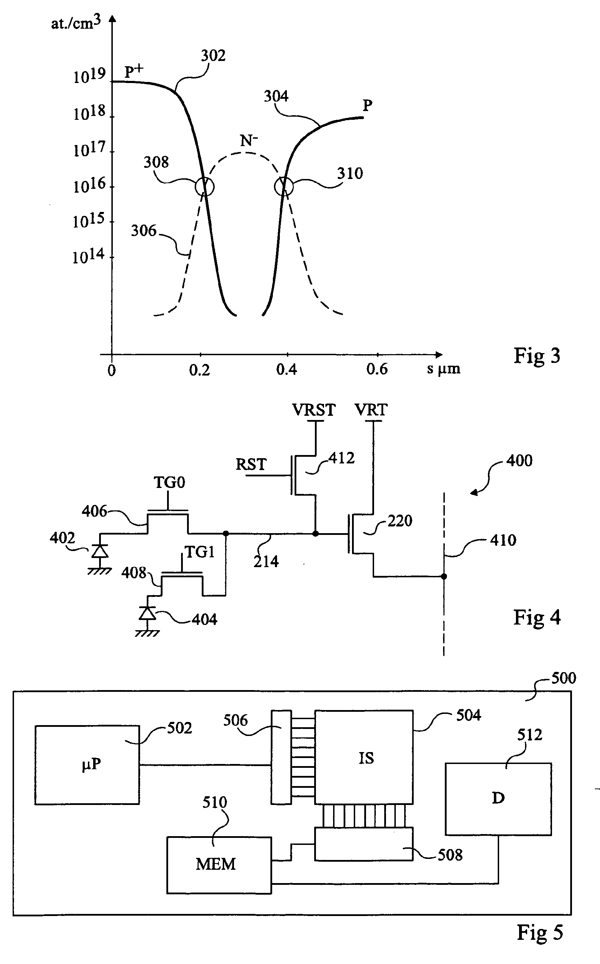

La figure 3 est un graphique illustrant à titre d'exemple les concentrations de dopage de type P et de type N en travers de la photodiode, par exemple à la profondeur d'un trait en pointillés 226 dans le substrat de la figure 2. Une implantation profonde à haute énergie peut être utilisée pour obtenir des concentrations de dopants satisfaisantes sur une profondeur de 1,2 µm ou plus.

Les exemples de concentration de dopage selon l'axe y en atomes par cm³ sont approchés et l'axe y utilise une échelle logarithmique. Les valeurs s de distance sont représentées sur l'axe x et correspondent par exemple à la distance en allant de la gauche vers la droite à partir de l'isolement à tranchée profonde 204 de la figure 2.

Le dopage de type P utilisé pour former la région de type P fortement dopée 210 résulte par exemple des concentrations de dopage illustrées par la courbe 302, présentant une concentration de dopage maximum de 10¹⁹ at./cm³ ou plus et chutant à une concentration très faible inférieure à 10¹⁴ at./cm³ en se déplaçant dans la région de type N 208. Le dopage de type P utilisé pour former le substrat de type P résulte par exemple des concentrations de dopage illustrées par la courbe 304 ayant un maximum d'environ 10¹⁸ at./cm3 et chutant à une concentration inférieure à 10¹⁴ at./cm³ quand on se déplace dans la région de type N 208. Le dopage de la région de type N est illustré par la courbe en pointillés 306 et atteint par exemple un maximum de 10¹⁷ at./cm³ près du centre de la région 208 et chute à des valeurs inférieures à 10¹⁴ at./cm³ quand on se déplace vers les régions de type P 210 et 202 de chaque côté. Les points de croisement des courbes 302, 304 avec la courbe 306, désignés respectivement par les références 308 et 310 en figure 3, correspondent par exemple à des concentrations de dopage dans la plage de 10¹⁶ à 10¹⁷ at./cm³ et c'est la distance entre ces points qui détermine la largeur de la région de type N, égale dans cet exemple à environ 0,2 µm. Ainsi, la région de type N 208 est pincée entre les région de type P, permettant d'obtenir une région de type N relativement étroite et profonde et autorisant l'évacuation des charges de cette région de la photodiode par une région centrale au niveau de dopage le plus élevé grâce à un contrôle latéral de l'anode de type N constituée de la région 208 par les cathodes constituées par des régions 210 et 202. Ainsi, ceci favorise un transfert de charge à partir du haut de la région 208.

La figure 4 représente un exemple de circuit de pixel 400 d'un capteur d'image comprenant un circuit de pixel de type 2T. Dans cet exemple, les photodiodes 402, 404 des deux régions de pixels sont couplées à un noeud de lecture commun 214 par l'intermédiaire de transistors de transfert respectifs 406, 408 qui reçoivent des tensions de transfert correspondantes TG0 et TG1. Chacune des photodiodes 402, 404 a par exemple la structure décrite ci-dessus en relation avec la figure 2.

Le circuit de lecture du circuit de pixel 400 comprend un transistor à source suiveuse 220 ayant sa grille couplée au noeud de lecture 214 et sa source couplée à une ligne de sortie 410. Un transistor de remise à zéro 412 est couplé entre le noeud de lecture 214 et une tension de remise à zéro VRST, et reçoit sur sa grille un signal de remise à zéro permettant de réinitialiser à la tension VRST le noeud de lecture 214.

La figure 5 représente un dispositif électronique 500, comprenant un microprocesseur 502 et un capteur d'image 504 comprenant par exemple un réseau de pixels tel que décrit ici et associé à un circuit de commande 506 qui produit des signaux pour commander les circuits de pixel du capteur d'image, tel que des tensions de transfert pour application à la grille du transistor de transfert, des tensions de lecture et/ou des signaux de remise à zéro du noeud de lecture. Le circuit de lecture 508 est également couplé au capteur d'image, comprenant par exemple des commutateurs et des condensateurs pour échantillonner et mémoriser des valeurs de tension vues à partir des lignes de lecture de colonne du capteur d'image 504. Une mémoire 510 mémorise des images captées par le capteur d'image et un affichage 512 affiche les images captées.

Le dispositif électronique 500 est par exemple un appareil photographique et/ou une caméra numérique, un dispositif portable ou une console de jeu portable ayant des capacités de capture d'image, une caméra d'ordinateur, un calculateur portable ou autre dispositif de capture d'image numérique comprenant un capteur d'image adapté à capter des images fixes ou mobiles.

Un avantage des modes de réalisation décrits ici est que la dimension de la région N 208 de la photodiode peut être agrandie sans réduire l'efficacité du transfert de charge vers le noeud de lecture 214.

Alors que plusieurs modes de réalisation particuliers ont été décrits, il sera clair pour l'homme de l'art que diverses modifications et variantes peuvent être utilisées.

Par exemple, dans certains modes de réalisation, les isolements par tranchées profondes 204, 206 qui délimitent les pixels peuvent être remplacés par des isolements par tranchées peu profondes. Dans certains modes de réalisation, le transistor à source suiveuse 220 n'est pas formé dans la région de pixel mais au voisinage des pixels, en même temps que d'autres transistors tels que les transistors de remise à zéro et de lecture des circuits de pixel.

Bien qu'un exemple d'un circuit de pixel soit représenté en figure 4, il sera clair pour l'homme de l'art que la structure de la photodiode décrite ci-dessus peut être utilisée dans divers circuits de pixel.

Il sera clair pour l'homme de l'art que les caractéristiques décrites en relation avec les divers modes de réalisation peuvent être combinées de diverses manières.

## Revendications

1. Capteur d'image comprenant une pluralité de pixels dont chacun comprend :
une région de recueil de charge (208) comprenant une région de type N (208) délimitée par des régions de type P (202, 210) et surmontée d'une couche (218) de type P ;
une région de lecture de type N (214); et
une électrode de grille isolée (216) disposée au-dessus de ladite couche de type P et agencée pour recevoir une tension de grille pour transporter des charges stockées dans la région de recueil de charge à travers la couche de type P vers la région de lecture (214),la région de lecture (214) étant disposée dans le substrat de type P (202) à côté de l'électrode de grille isolée ; et **caractérisé en ce que** :
la région de lecture (214) est disposée d'un côté en projection de la région de recueil de charge (208), recouvre partiellement la région de recueil de charge (208), et s'étend au-delà de la projection de la région de recueil de charge (208).

2. Capteur d'image selon la revendication 1, dans lequel, d'au moins un côté, une des régions de type P est une région de type P fortement dopée entre la région de recueil de charge et une tranchée d'isolement (204).

3. Capteur d'image selon la revendication 1 ou 2, dans lequel la région de recueil de charge (208) est délimitée sur au moins un côté par une région de substrat de type P (202), et dans lequel la couche de type P (218) a une concentration de dopage plus faible que le substrat de type P.

4. Capteur d'image selon l'une quelconque des revendications 1 à 3, dans lequel la région de recueil de charge (208) a une profondeur comprise entre 0,5 et 2 µm.

5. Capteur d'image selon l'une quelconque des revendications 1 à 4, dans lequel la région de recueil de charge (208) a une largeur comprise entre 0,05 et 0,4 µm.

6. Capteur d'image selon l'une quelconque des revendications 1 à 5, dans lequel la région de type N de la région de recueil de charge (208) a une concentration de dopage dans la plage de 10¹⁵ à 5x10¹⁷ at./cm³.

7. Capteur d'image selon l'une quelconque des revendications 1 à 6, dans lequel la couche de type P (218) a une concentration de dopage comprise entre 10¹⁶ et 10¹⁸ at./cm³.

8. Capteur d'image selon l'une quelconque des revendications 1 à 7, dans lequel la couche de type P (218) a une épaisseur comprise entre 20 et 150 nm.

9. Capteur d'image selon l'une quelconque des revendications 1 à 8, dans lequel chaque pixel comprend en outre un transistor à source suiveuse (220) formé dans une région de pixel délimitée par des tranchées d'isolement (204, 206), le transistor à source suiveuse étant isolé d'au moins un côté par isolement à tranchée peu profonde (222).

10. Dispositif électronique comprenant le capteur d'image selon l'une quelconque des revendications 1 à 9.

11. Téléphone mobile comprenant le capteur d'image selon l'une quelconque des revendications 1 à 9.

12. Procédé de fabrication d'un capteur d'image comprenant la formation de chaque pixel du capteur d'image en :
délimitant une région de type N d'une région de recueil de charge (208) par des régions de type P (202, 210), la région de recueil de charge étant surmontée par et une couche (218) de type P ;
formant une région de lecture de type N (214) ; et
formant, au-dessus la couche de type P (218), une électrode de grille isolée (216) agencée pour recevoir une tension de grille pour transporter des charges à travers la couche de type P vers la région de lecture (214), la région de lecture (214) étant disposée dans le substrat de type P à côté de l'électrode de grille isolée (216), et **caractérisé en ce que** la région de lecture (214) est disposée d'un côté en projection de la région de recueil de charge (208), recouvre partiellement la région de recueil de charge (208), et s'étend au-delà de la projection de la région de recueil de charge (208).

## Patentansprüche

1. Ein Bildsensor, der eine Vielzahl von Pixeln aufweist, wobei Folgendes vorgesehen ist:
eine Ladungssammelregion (208), die eine N-Typ-Region (208) begrenzt durch P-Typ-Regionen (202, 210) aufweist, und mit einer darüber liegenden P-Typ-Schicht (218);
eine N-Typ-Abfühlregion (214); und
eine isolierte Gateelektrode (216) positioniert über der P-Typ-Schicht und angeordnet, um eine Gatespannung zu empfangen für den Transport von Ladungen, gespeichert in der Ladungssammelregion durch die P-Typ-Schicht zu der Abfühlregion (214) zu transportieren, wobei die Abfühlregion (214) in dem P-Typ-Substrat (202) positioniert ist, und zwar benachbart zu der erwähnten isolierten Gateelektrode und ferner **dadurch gekennzeichnet, dass**:
die Abfühlregion (214) auf einer Seite in Projektion der Ladungssammelregion (208) positioniert ist und partiell die Sammelregion (208) abdeckt und sich nach außen von der Projektion der Ladungssammelregion (208) erstreckt.

2. Der Bildsensor nach Anspruch 1, wobei auf mindestens einer Seite von einer der erwähnten P-Typ-Regionen eine stark dotierte P-Typ-Region zwischen der Ladungssammelregion und einem Isolationsgraben (204) vorgesehen ist.

3. Der Bildsensor nach Anspruch 1 oder 2, wobei die Ladungssammelregion (208) begrenzt ist auf mindestens einer Seite durch eine Region (202) eines P-Typ-Substrats, wobei die erwähnte P-Typ-Schicht (218) eine höhere Dotierkonzentration besitzt als das erwähnte P-Typ-Substrat.

4. Der Bildsensor nach einem der Ansprüche 1 bis 3, wobei die Ladungssammelregion (208) eine Tiefe zwischen 0,5 µm und 2 µm besitzt.

5. Der Bildsensor nach einem der Ansprüche 1 bis 4, wobei die Ladungssammelregion (208) eine Breite von zwischen 0,05 µm und 0,4 µm besitzt.

6. Der Bildsensor nach einem der Ansprüche 1 bis 5, wobei die N-Typ-Region der Ladungssammelregion (208) eine Dotierkonzentration im Bereich 10¹⁵ bis 5 x 10¹⁷ at./cm³ besitzt.

7. Der Bildsensor nach einem der Ansprüche 1 bis 6, wobei die P-Typ-Schicht (218) eine Dotierkonzentration von zwischen 10¹⁶ und 10¹⁸ at./cm³ besitzt.

8. Der Bildsensor nach einem der Ansprüche 1 bis 7, wobei die P-Typ-Schicht (218) eine Dicke zwischen 20 und 150 nm besitzt.

9. Der Bildsensor nach einem der Ansprüche 1 bis 8, wobei jedes Pixel ferner einen Source-Folge-Transistor (220) ausgeformt innerhalb einer Pixelregion aufweist, und zwar begrenzt durch Isolationsgräben (204, 206), wobei der Source-Folge-Transistor isoliert ist, mindestens einseitig durch eine flache Grabenisolierung (222).

10. Eine elektronische Vorrichtung, die einen Bildsensor nach einem der Ansprüche 1 bis 9 aufweist.

11. Ein Mobiltelefon, welches den Bildsensor nach einem der Ansprüche 1 bis 9 aufweist.

12. Ein Verfahren zur Herstellung eines Bildsensors, wobei zum Formen jedes Pixels des Bildsensors Folgendes vorgesehen ist:
Begrenzen einer N-Typ-Region einer Ladungssammelregion (208) durch P-Typ-Regionen (202, 210) und eine darüberliegende P-Typ-Schicht (218), wobei die Ladungssammelregion durch eine P-Typ-Schicht (218) abgedeckt ist;
Fomen einer N-Typ-Abfühl- oder Sensor-Region (214); und
Formen einer isolierten Gate-Elektrode (216) über der erwähnten P-Typ-Schicht (218), angeordnet zum Empfang einer Gatespannung für die Übertragung von Ladungen durch die erwähne P-Typ-Schicht zu der erwähnten Abfühlregion (214), wobei die Abfühlregion (214) in dem P-Typ-Substrat positioniert ist, und zwar benachbart zu der isolierten Gate-Elektrode (216) und **dadurch gekennzeichnet, dass** die Abfühlregion (214) an einer Seite in Projektion der Ladungssammelregion (208) positioniert ist und teilweise die Ladungssammelregion (208) überdeckt und sich nach außen von der Projektion der Ladungssammelregion (208) erstreckt.

## Claims

1. An image sensor comprising a plurality of pixels each comprising:
a charge collection region (208) comprising an N-type region (208) bounded by P-type regions (202, 210) and having an overlying P-type layer (218);
an N-type sensing region (214); and
an insulated gate electrode (216) positioned over said P-type layer and arranged to receive a gate voltage for conveying charges stored in the charge collection region through the P-type layer towards the sensing region (214), the sensing region (214) being positioned in the P-type substrate (202), adjacent to said insulated gate electrode; and **characterized in that**:
the sensing region (214) is positioned on one side, in projection, of the charge collection region (208), partially covers the charge collection region (208), and extends outwards of the projection of the charge collection region (208).

2. The image sensor of claim 1, wherein, on at least one side, one of said P-type regions is a heavily doped P-type region between said charge collection region and an insulation trench (204).

3. The image sensor of claim 1 or 2, wherein said charge collection region (208) is bounded on at least one side by a region (202) of a P-type substrate, and wherein said P-type layer (218) has a higher doping concentration than said P-type substrate.

4. The image sensor of any of claims 1 to 3, wherein the charge collection region (208) has a depth of between 0.5 µm and 2 µm.

5. The image sensor of any of claims 1 to 4, wherein the charge collection region (208) has a width of between 0.05 µm and 0.4 µm.

6. The image sensor of any of claims 1 to 5, wherein said N-type region of the charge collection region (208) has a doping concentration in the range of 10¹⁵ to 5x10¹⁷ at./cm³.

7. The image sensor of any of claims 1 to 6, wherein said P-type layer (218) has a doping concentration of between 10¹⁶ and 10¹⁸ at./cm³.

8. The image sensor of any of claims 1 to 7, wherein said P-type layer (218) has a thickness of between 20 and 150 nm.

9. The image sensor of any of claims 1 to 8, wherein each pixel further comprises a source follower transistor (220) formed within a pixel region delimited by isolation trenches (204, 206), said source following transistor being isolated on at least one side by a shallow trench isolation (222).

10. An electronic device comprising the image sensor of any of claims 1 to 9.

11. A mobile telephone comprising the image sensor of any of claims 1 to 9.

12. A method of manufacturing an image sensor comprising forming each pixel of said image sensor by:
delimiting an N-type region of a charge collection region (208) by P-type regions (202, 210) and an overlying P-type layer (218), the charge collection region being covered by a P-type layer (218);
forming an N-type sensing region (214); and
forming an insulated gate electrode (216) over said P-type layer (218), arranged to receive a gate voltage for conveying charges through said P-type layer towards said sensing region (214), the sensing region (214) being positioned in the P-type substrate, adjacent to said insulated gate electrode (216); and **characterized in that** the sensing region (214) is positioned on one side, in projection, of the charge collection region (208), partially covers the charge collection region (208), and extends outwards of the projection of the charge collection region (208).
